(19) Europäisches Patentamt
European Patent Office
Office européen des brevets

(11) EP 4 783 458 A1

(12) **EUROPEAN PATENT APPLICATION**

(43) Date of publication:
**29.07.2026 Bulletin 2026/31**

(21) Application number: **25219920.3**

(22) Date of filing: **01.12.2025**

(51) International Patent Classification (IPC):
**H03F 1/56** (2006.01)   **H03F 3/195** (2006.01)
**H03F 3/21** (2006.01)   **H03F 1/02** (2006.01)

(52) Cooperative Patent Classification (CPC):
**H03F 3/195; H03F 1/0288; H03F 1/565; H03F 3/21;**
H03F 2200/222; H03F 2200/225; H03F 2200/387;
H03F 2200/391; H03F 2200/399; H03F 2200/402;
H03F 2200/451; H03F 2203/21169;
H03F 2203/21172

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **24.01.2025   CN 202510117838
24.01.2025   CN 202520169049 U
24.01.2025   CN 202520168875 U**

(71) Applicant: **Xiamen San'an Integrated Circuit Co.,
Ltd.
Xiamen, Fujian 361100 (CN)**

(72) Inventors:
• **LIU, Tonghe
Xiamen City, Fujian Province, 361100 (CN)**
• **CAI, Wenbi
Xiamen City, Fujian Province, 361100 (CN)**

(74) Representative: **JD&P Patent Attorneys
Joanna Dargiewicz & Partners
ul. Mysliborska 93A/50
03-185 Warszawa (PL)**

(54) **RADIO FREQUENCY POWER AMPLIFIER AND COMMUNICATION DEVICE**

(57)    A radio frequency power amplifier includes a supporting substrate and a first amplifying branch. The supporting substrate is provided with a ground terminal. The first amplifying branch includes a first connection terminal, a second connection terminal, a first impedance matching network, a second impedance matching network, a first transistor and a first parasitic capacitance resonance network. The first transistor includes a gate and a drain. The first impedance matching network is electrically connected between the first connection terminal and the gate of the first transistor. The second impedance matching network is electrically connected between the drain of the first transistor and the second connection terminal. The first parasitic capacitance resonance network is electrically connected between the drain of the first transistor and the ground terminal. Compared with the prior art, the amplification efficiency of the radio frequency power amplifier can be improved.

FIG. 1

EP 4 783 458 A1

**Description**

Field of the Invention

The invention relates to the field of radio frequency, in particular to a radio frequency power amplifier and a communication device.

Background of the Invention

With the wide application of GaN-based high electron mobility transistor (HEMT) devices, the integration of harmonic matching and fundamental matching in a package becomes a hotspot in device design. Such a design faces two challenges: first, the influence of a harmonic tuning circuit on a fundamental impedance matching circuit, particularly on the bandwidth, needs be controlled to the greatest extent; second, because a matching network needs to satisfy both the requirement for fundamental matching and the requirement for harmonic matching, yet component values for the harmonic frequency band are obviously smaller than component values required for the fundamental frequency band, the matching topology needs to be optimized and corresponding fabrication processes need to be selected for the power capacity of components to highly reliably realize harmonic matching and fundamental matching in the same package.

Summary of the Invention

To solve the aforesaid problems, the invention provides a radio frequency power amplifier, which can realize harmonic matching and fundamental matching in a package, while optimizing the power capacity of passive components to improve the device reliability.

In one aspect, a radio frequency power amplifier includes a supporting substrate and a first amplifying branch, wherein the supporting substrate is provided with a ground terminal; wherein the first amplifying branch comprises a first connection terminal, a second connection terminal, a first impedance matching network, a second impedance matching network, a first transistor, and a first parasitic capacitance resonance network. The first transistor comprises a gate and a drain; the first impedance matching network is electrically connected between the first connection terminal and the gate of the first transistor; the second impedance matching network is electrically connected between the drain of the first transistor and the second connection terminal; the first parasitic capacitance resonance network is electrically connected between the drain of the first transistor and the ground terminal; the first parasitic capacitance resonance network is configured to resonate with an output parasitic capacitance of the first transistor and participate in fundamental matching, and exhibit inductive characteristics within a fundamental band of the radio frequency power amplifier.

In some embodiments, the radio frequency power amplifier further comprises a second amplifying branch. The first amplifying branch is configured for peak amplification; the second amplifying branch is configured for carrier amplification; the second amplifying branch comprises a third connection terminal, a fourth connection terminal, a third impedance matching network, a fourth impedance matching network, a second transistor and a second parasitic capacitance resonance network; the second transistor comprises a gate and a drain; the third impedance matching network is electrically connected between the third connection terminal and the gate of the second transistor; the fourth impedance matching network is electrically connected between the drain of the second transistor and the fourth connection terminal; the second parasitic capacitance resonance network is electrically connected between the drain of the second transistor and the ground terminal; the second parasitic capacitance resonance network is configured to resonate with an output parasitic capacitance of the second transistor and participate in fundamental matching, and exhibit inductive characteristics within the fundamental band of the radio frequency power amplifier.

In another aspect, a communication device is provided which includes the radio frequency power amplifier as described above.

In the radio frequency power amplifier provided by the invention, a first harmonic tuning network and a first parasitic capacitance resonance network are combined into a single network. The first parasitic capacitance resonance network includes a first inductor and the first harmonic tuning network, which resonates with the output parasitic capacitance of a first transistor while tuning its output harmonic impedance, such that the first harmonic tuning network has less influence on fundamental matching. Test results show that the efficiency of the radio frequency power amplifier provided by the invention is improved. In high-power power amplifier applications where the harmonic matching network needs to withstand extremely high power, the radio frequency power amplifier provided by the invention may be used to withstand higher power and improve the device reliability.

Brief Description of the Drawings

FIG. 1 illustrates a schematic circuit diagram of a radio frequency power amplifier according to Embodiment 1;

FIG. 2 illustrates a schematic circuit diagram of a first impedance matching network of the radio frequency power amplifier according to Embodiment 1;

FIG. 3 illustrates a schematic circuit diagram of a first parasitic capacitance resonance network of the radio frequency power amplifier according to Embodiment 1;

FIG. 4 illustrates a schematic circuit diagram of a first harmonic tuning network of the first parasitic capacitance resonance network according to Embodiment 1;

FIG. 5 illustrates a schematic diagram of a third inductor of a second impedance matching network of the radio frequency power amplifier according to Embodiment 1;

FIG. 6 illustrates schematic diagrams of two implementations of the second impedance matching network of the radio frequency power amplifier according to Embodiment 1;

FIG. 7 illustrates a schematic diagram of an output equivalent circuit of a first transistor;

FIG. 8 illustrates a schematic equivalent diagram of a Bode-Fano limit;

FIG. 9 illustrates a comparison chart of the insertion loss of the invention and the insertion loss of a comparative example at different frequencies;

FIG. 10 illustrates a chart of the equivalent capacitance achieved by a fourth inductor and a third capacitor, which are connected in series, at different frequencies according to Embodiment 1 of the invention;

FIG. 11 illustrates a comparison chart of VBW resonance points with and without the fourth inductor according to the invention;

FIG. 12 illustrates a schematic diagram of the radio frequency power amplifier according to Embodiment 1;

FIG. 13 illustrates a schematic enlarged view of part C of the radio frequency power amplifier according to Embodiment 1;

FIG. 14 illustrates a schematic cross-sectional view along 1B-1B' of the radio frequency power amplifier according to Embodiment 1;

FIG. 15 illustrates a schematic enlarged view of part D3 of FIG. 12;

FIG. 16 illustrates a schematic enlarged view at the position of the third capacitor;

FIG. 17 illustrates a chart of the equivalent inductance of the first harmonic tuning network when the capacitance of a second capacitor is swept from 0.1 pF to 3.9 pF;

FIG. 18 illustrates a variation of the second harmonic impedance of a node B when the capacitance C2 of the second capacitor is swept from 1 pF to 3 pF;

FIG. 19 illustrates load-pull simulation results of a power amplifier according to the comparative example;

FIG. 20 illustrates load-pull simulation results of the power amplifier according to one embodiment of the invention.

FIG. 21 is an enlarged view of a first amplifying branch of the radio frequency power amplifier of FIG. 12.

FIG. 22 is an enlarged view of a second amplifying branch of the radio frequency power amplifier of FIG. 12.

FIG. 23 illustrates a schematic circuit diagram of the second amplifying branch of the radio frequency power amplifier according to Embodiment 2;

FIG. 24 illustrates a schematic circuit diagram of a third impedance matching network of the radio frequency power amplifier according to Embodiment 2;

FIG. 25 illustrates a schematic circuit diagram of a second parasitic capacitance resonance network of the radio frequency power amplifier according to Embodiment 2;

FIG. 26 illustrates a schematic circuit diagram of a second harmonic tuning network of the second parasitic capacitance resonance network according to Embodiment 2;

FIG. 27 illustrates a schematic diagram of a tenth inductor of the fourth impedance matching network of the radio frequency power amplifier according to Embodiment 2;

FIG. 28 illustrates schematic diagrams of two implementations of the fourth impedance matching network of the radio frequency power amplifier according to Embodiment 2;

Detailed Description of the Invention

The invention is further explained below in conjunction with accompanying drawings and specific embodiments.

In the description of the invention, it should be noted that terms such as "upper", "lower", "left", "right", "vertical", "horizontal", "inner" and "outer" are used to indicate directional or positional relations based on the accompanying drawings or common directional or positional relations in use of the product of the invention. They are used merely for the purpose of facilitating and simplifying the description of the invention, and do not indicate or imply that devices or elements referred to must be in a specific direction or be configured and operated in a specific direction, and thus should not be construed as limitations of the invention. In addition, terms such as "first", "second" and "third" are merely for descriptive distinction and should not be construed as indicating or implying relative importance. The drawings in the description of the invention are merely illustrative. It should be noted that sizes of components in the drawings are not drawn to actual scale.

## Embodiment 1

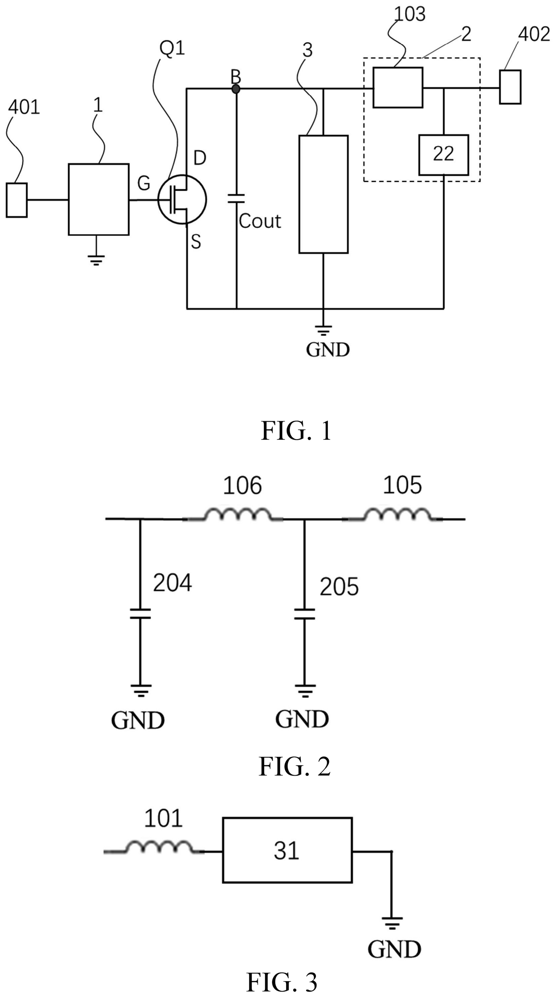

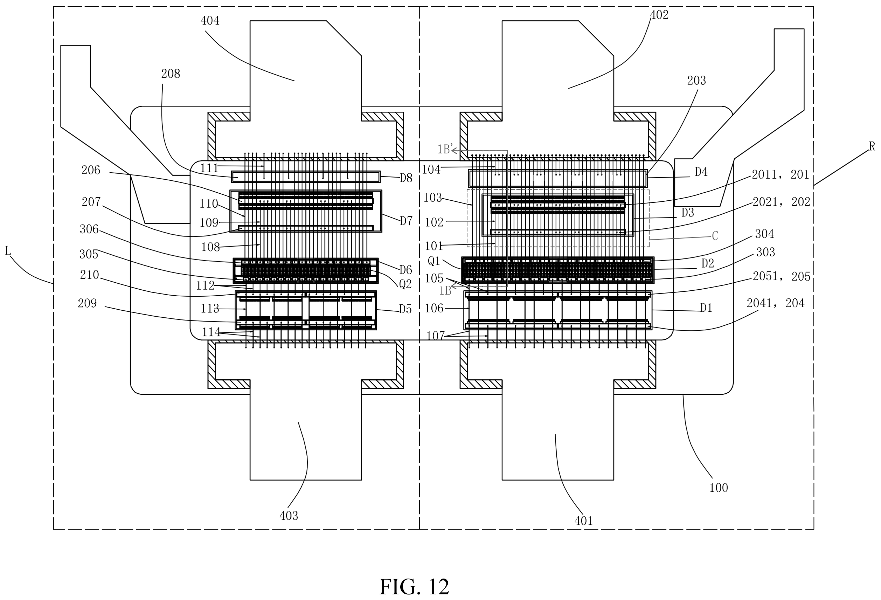

This embodiment of the invention provides a radio frequency power amplifier, which as shown in FIGS. 1, 12 and 21, includes a supporting substrate 100 and a first amplifying branch (the right half R in FIG. 12). The supporting substrate 100 is provided with a ground terminal GND. The first amplifying branch includes a first connection terminal 401, a second connection terminal 402, a first impedance matching network 1, a second impedance matching network 2, a first transistor Q1, and a first parasitic capacitance resonance network 3. The first transistor Q1 includes a gate 303 (G terminal in FIG. 1), a drain 304 (D terminal in FIG. 1), and a source S. The first impedance matching network 1 is electrically connected between the first connection terminal 401 and the gate 303 of the first transistor Q1. The second impedance matching network 2 is electrically connected between the drain 304 of the first transistor Q1 and the second connection terminal 402. The first parasitic capacitance resonance network 3 is electrically connected between the drain 304 of the first transistor and the ground terminal GND. The first parasitic capacitance resonance network 3 is configured to resonate with an output parasitic capacitance of the first transistor Q1 and participate in fundamental matching, and exhibit inductive characteristics within a fundamental frequency band of the radio frequency power amplifier. The first connection terminal 401 is a radio frequency signal input terminal of the first amplifying branch, and the second connection terminal 402 is a radio frequency signal output terminal of the first amplifying branch. It should be noted that a source of the first transistor Q1 is electrically connected to the ground terminal GND of the supporting substrate 100. The first transistor Q1 includes a substrate and an epitaxial layer arranged on the substrate. The first transistor Q1 is provided with a through-hole. A conductive metal layer is arranged on a backside of the substrate and electrically connected to the ground terminal GND of the supporting substrate 100. The source of the first transistor Q1 is electrically connected to the conductive metal layer. The first amplifying branch is packaged in the radio frequency power amplifier. In one specific embodiment of the invention, the first transistor Q1 is a gallium nitride high electron mobility transistor (GaN HEMT) device, and the supporting substrate is a conductive supporting substrate.

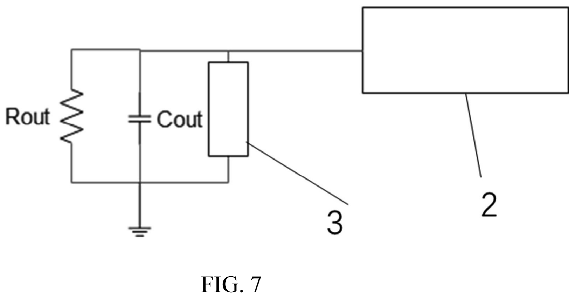

An output equivalent circuit of the first transistor Q1 is shown in FIG. 7. When the first parasitic capacitance resonance network 3 exhibits the inductive characteristics, the first parasitic capacitance resonance network 3 is equivalent to a ground inductor within the fundamental frequency band. The ground inductor is configured to resonate with the output parasitic capacitance Cout of the first transistor Q1, such that the equivalent output capacitance of the first transistor is equivalently reduced in the vicinity of the resonant frequency.

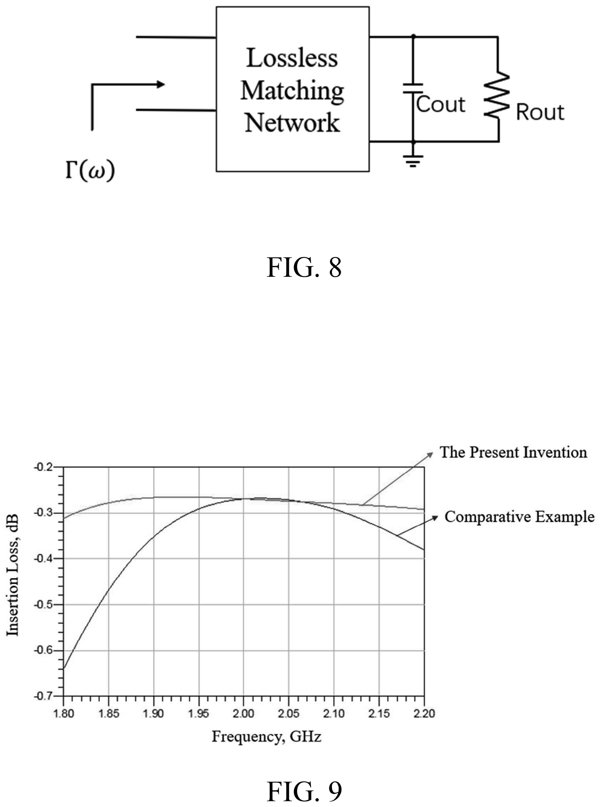

According to Bode-Fano limit equation (1), as shown in FIG. 8,

$$\int_0^\infty ln\left[\frac{1}{|\Gamma(\omega)|}\right] d\omega \leq \frac{\pi}{R_{out}C_{out}} \qquad (1)$$

where, $\Gamma(\omega)$ is a reflection coefficient, $R_{out}$ is an optimal load impedance of an output terminal of the transistor, and $C_{out}$ is the output parasitic capacitance of the transistor.

The bandwidth of an RC parallel circuit is inversely proportional to the product ($R_{out}C_{out}$) of $R_{out}$ and $C_{out}$. When the output parasitic capacitance of the first transistor resonates with the first parasitic capacitance resonance network 3, the equivalent capacitance is decreased, and the bandwidth of the matching network is increased.

In a specific embodiment of the invention, as shown in FIGS. 3, 4, 12 and 21, the first parasitic capacitance resonance network 3 includes a first inductor 101 and a first harmonic tuning network 31. The first harmonic tuning network 31 is configured to adjust the phase of a second harmonic (2f0) impedance. The first harmonic tuning network 31 includes a second inductor 102, a first capacitor 201 and a second capacitor 202. One terminal of the first inductor 101 is electrically connected to the drain 304 of the first transistor Q1; the other terminal of the first inductor 101 is electrically connected to one terminal of the second inductor 102, and the other terminal of the second inductor 102 is electrically connected to one terminal of the first capacitor 201; the other terminal of the first capacitor 201 is electrically connected to the ground terminal GND; and one terminal of the second capacitor 202 is connected to a joint between the first inductor 101 and the second inductor 102, and the other terminal of the second capacitor 202 is connected to the ground terminal GND.

FIG. 9 illustrates a comparison of insertion loss between the present invention and a comparative example at different frequencies. The radio frequency power amplifier of the present invention includes the first parasitic capacitance resonance network 3, while the comparative example represents an output of a radio frequency power amplifier that does not include the first parasitic capacitance resonance network 3. It can be seen, from FIG. 9, that the insertion loss of the invention is generally less than the insertion loss of the comparative example within 1.8 GHz - 2.20 GHz. The insertion loss of the comparative example within 1.80 GHz - 1.93 GHz and 2.12 GHz - 2.20 GHz is less than -0.3dB. The insertion loss of the invention within 1.8 GHz - 2.20 GHz is greater than -0.3dB. By introducing the first parasitic capacitance resonance network 3 in the present invention, the output bandwidth of the first transistor Q1 can be increased.

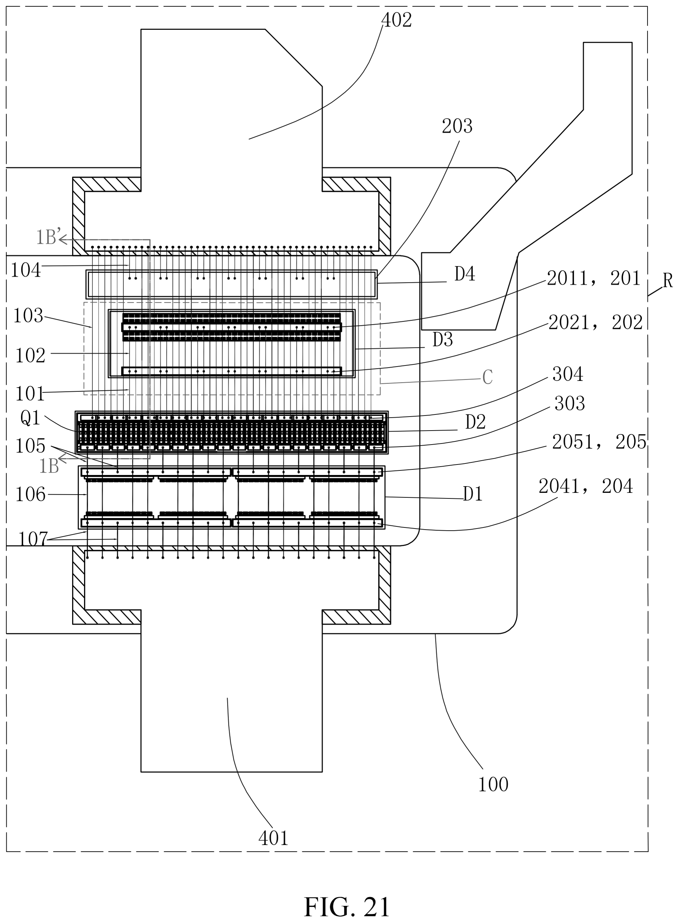

As shown in FIGS. 12 and 21 and described above, the radio frequency power amplifier includes the supporting substrate 100 and the first amplifying branch (the right half in FIG. 12). The supporting substrate 100 is provided with the ground terminal GND. A first element region D1, a second element region D2, a third element region D3 and a fourth element region D4 are arranged on the supporting substrate 100.

In a specific embodiment, as shown in FIGS. 2, 12 and 21, the first impedance matching network 1 includes a fifth inductor 105, a sixth inductor 106, a fourth capacitor 204 and a fifth capacitor 205. The first impedance matching network 1 is configured for series resonance with an input parasitic capacitance of the first transistor Q1 and participates in fundamental matching. One terminal of the sixth inductor 106 is electrically connected to the first connection terminal 401 by means of a first group of bonding wires 107, the other terminal of the sixth inductor 106 is electrically connected to one terminal of the fifth inductor 105, the other terminal of the fifth inductor 105 is electrically connected to the gate 303 of the first transistor. One terminal of the fourth capacitor 204 is electrically connected to the one terminal of the sixth inductor 106, and the other terminal of the fourth capacitor 204 is electrically connected to the ground terminal GND. One terminal of the fifth capacitor 205 is electrically connected to the other terminal of the sixth inductor 106, and the other terminal of the fifth capacitor 205 is electrically connected to the ground terminal GND.

The fourth capacitor 204 and the fifth capacitor 205 in the first impedance matching network 1 are arranged in the first element region D1. The fourth capacitor 204 and the fifth capacitor 205 are an IPD chip and are formed by a second integrated capacitor. The IPD chip (i.e. the second integrated capacitor) includes a second semiconductor substrate. Each of the fourth capacitor 204 and the fifth capacitor 205 is a metal-insulator-metal (MIM) capacitor structure (not shown) arranged on the second semiconductor substrate, including an upper plate electrode, a lower plate electrode and an intermediate dielectric layer. Each of the upper plate electrode and the lower plate electrode is a metal layer. The lower plate electrode is arranged on an upper surface of the second semiconductor substrate and connected to a second backside metal layer on a lower surface of the second semiconductor substate by means of a through-hole. The backside metal layer on the lower surface of the semiconductor substate of the IPD chip is in conductive contact with the ground terminal GND of the supporting substrate 100. It should be noted that the intermediate dielectric layer of the fourth capacitor 204 and the intermediate dielectric layer of the fifth capacitor 205 may have the same thickness or may have different thicknesses. In this embodiment, preferably, the second semiconductor substrate is a GaAs substrate, and the intermediate dielectric layers of the fourth capacitor 204 and the fifth capacitor 205 have the same thickness. The metal layers of the upper plate electrodes of the fourth capacitor 204 and the fifth capacitor 205 have the same thickness, and the metal layers of the lower plate electrodes of the fourth capacitor 204 and the fifth capacitor 205 have the same thickness. As shown in FIG. 12, the fourth capacitor 204 is provided with a fourth connection pad 2041, and the fourth connection pad 2041 is connected to the metal layer of the upper plate electrode of the fourth capacitor 204. The fifth capacitor 205 is provided with a fifth connection pad 2051, and the fifth connection pad 2051 is connected to the metal layer of the upper plate electrode of the fifth capacitor 205. The metal layer of the upper plate electrode of the fourth capacitor is electrically isolated from the metal layer of the upper plate electrode of the fifth capacitor. The sixth inductor 106 is formed by a group of bonding wires. One end of the group of bonding wires of the sixth inductor 106 is connected to the fourth connection pad 2041 of the fourth capacitor, and the other end of the group of bonding wires of the sixth inductor 106 is connected to the fifth connection pad 2051 of the fifth capacitor 205.

As shown in FIGS. 12, 13 and 21, the first transistor Q1 is arranged in the second element region D2, and the first harmonic tuning network 31 is arranged in the third element region D3. The first capacitor 201 and the second capacitor 202 of the first harmonic tuning network 31 are an IPD chip and are formed by a first integrated capacitor. The first integrated capacitor includes a first region where the first capacitor 201 is arranged and a second region where the second capacitor 202 is arranged. The first integrated capacitor includes a first semiconductor substrate 1000. The first semiconductor substrate 1000 includes a first surface, and a second surface opposite to the first surface. A first backside metal layer 1001 is arranged on the second surface of the first semiconductor substrate. In this embodiment, the first semiconductor substrate 1000 is preferably a GaAs substrate.

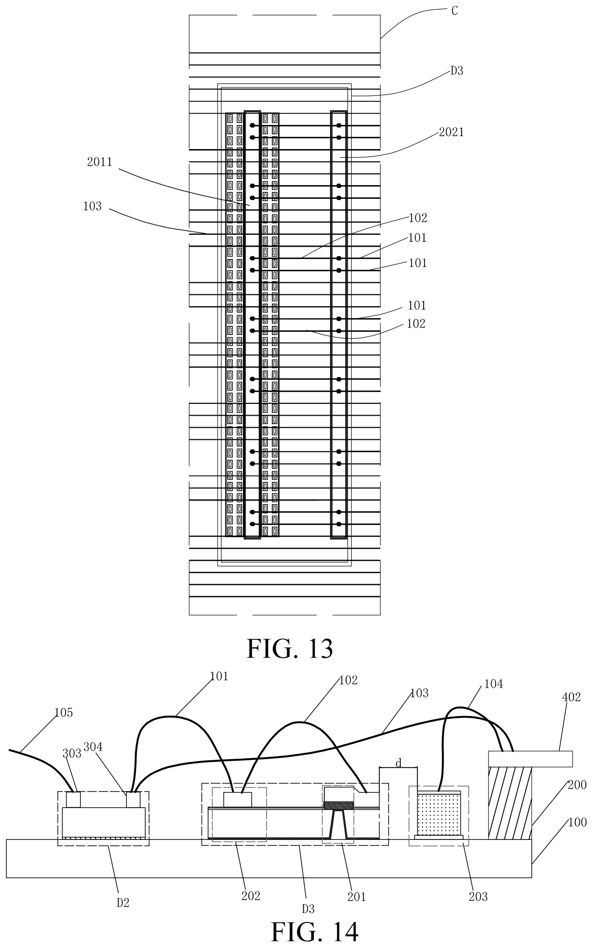

As shown in FIGS. 13, 14 and 15, the first capacitor 201 includes an MIM capacitor formed by a first metal layer 1003, a second dielectric layer 1004 and a second metal layer 1005A which are sequentially arranged in the first region on the first surface of the first semiconductor substrate 1000. The second capacitor 202 includes a first dielectric layer 1002, a second dielectric layer 1004 and a third metal layer 1005B which are arranged in the second region on the first surface of the first semiconductor substrate 1000, and a first backside metal layer 1001 arranged on the second surface of the first semiconductor substrate 1000. The first semiconductor substrate 1000 is provided with a through-hole 1006. It should be noted that, to improve heat dissipation, the through-hole 1006 is formed in the first region, and is provided with the first backside metal layer 1001, and the first backside metal layer 1001 in the through-hole 1006 is in contact and electrical connection with the first metal layer 1003 in the first region. In other embodiments, the through-hole 1006 may be located outside the first region, and a metal layer may be deposited in the through-hole 1006 to electrically connect the first metal layer 1003 in the first region with the first backside metal layer 1001 on the second surface of the first semiconductor substrate 1000.

The third metal layer 1005B of the second capacitor 202 also serves as a second connection pad 2021 of the second capacitor 202, eliminating the need for a separate connection pad. The second metal layer 1005A serves as an upper plate electrode of the first capacitor 201, and a first connection pad 2011 of the first capacitor 201 is electrically connected to the second metal layer 1005A. The upper plate electrode of the first capacitor 201 is arranged corresponding to the first metal layer 1003 of the first capacitor 201.

The thickness of the first dielectric layer 1002 is greater than the thickness of the second dielectric layer 1004 to reduce a parasitic capacitance generated by the first connection pad 2011 of the first capacitor 201 and the first backside metal layer 1001. The second metal layer 1005A in the first region and the third metal layer 1005B in the second region may be formed in the same process step but are electrically isolated from each other, and a distance between the second metal layer 1005A in the first region and the third metal layer 1005 in the second region is greater than or equal to 100 $\mu$m.

The first dielectric layer 1002 is made from silicon nitride and/or silicon oxide, and the second dielectric layer 1004 is made from silicon nitride and/or silicon oxide. It should be noted that the first dielectric layer 1002 may be of a single-layer or multi-layer dielectric structure. The second dielectric layer 1004 may be of a single-layer or multi-layer dielectric structure.

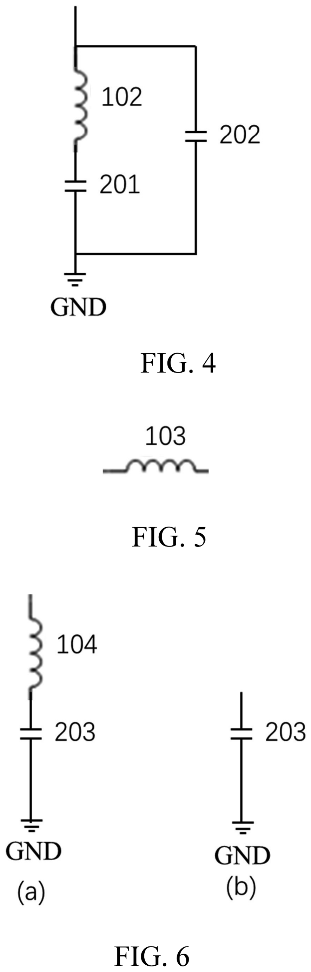

Further, the second impedance matching network 2 includes a parallel branch 22 and a series branch. The series branch is formed by a third inductor 103. As shown in FIG. 5, one terminal of the series branch is connected to the drain 304 of the first transistor Q1, the other terminal of the series branch is connected to the second connection terminal 402. One terminal of the parallel branch 22 is connected to the second connection terminal 402, and the other terminal of the parallel branch 22 is connected to the ground terminal GND.

In one embodiment of the invention, the parallel branch 22 of the second impedance matching network 2 shown in FIG. 6(b) includes a third capacitor 203. As Example 2, the second impedance matching network 2 includes the third inductor 103 and the third capacitor 203. The second impedance matching network 2 is configured to form a bandpass matching network to increase the output impedance at the fundamental frequency f0. One terminal of the third inductor 103 is electrically connected to the drain 304 of the first transistor, the other terminal of the third inductor 103 is electrically connected to the second connection terminal 402, and the third capacitor 203 is connected in parallel between the second connection terminal 402 and the ground terminal GND, i.e. one terminal of the third capacitor 203 is electrically connected to the second connection terminal 402, and the other terminal of the third capacitor 203 is connected to the ground terminal GND.

In another embodiment of the invention, the parallel branch 22 of the second impedance matching network 2 shown in FIG. 6(a) is a series matching network formed by a fourth inductor 104 and a third capacitor 203. As Example 1, the second impedance matching network 2 includes the third inductor 103, the fourth inductor 104 and the third capacitor 203. The second impedance matching network 2 is configured to form a bandpass matching network to increase the output impedance at the fundamental frequency. One terminal of the third inductor 103 is electrically connected to the drain 304 of the first transistor; the other terminal of the third inductor 103 is electrically connected to the second connection terminal 402; one terminal of the fourth inductor 104 is electrically connected to the second connection terminal 402, and the other terminal of the fourth inductor 104 is connected to one terminal of the third capacitor 203; and the other terminal of the third capacitor 203 is electrically connected to the ground terminal GND. As shown in FIG. 12, the third capacitor 203 is arranged in the fourth element region D4.

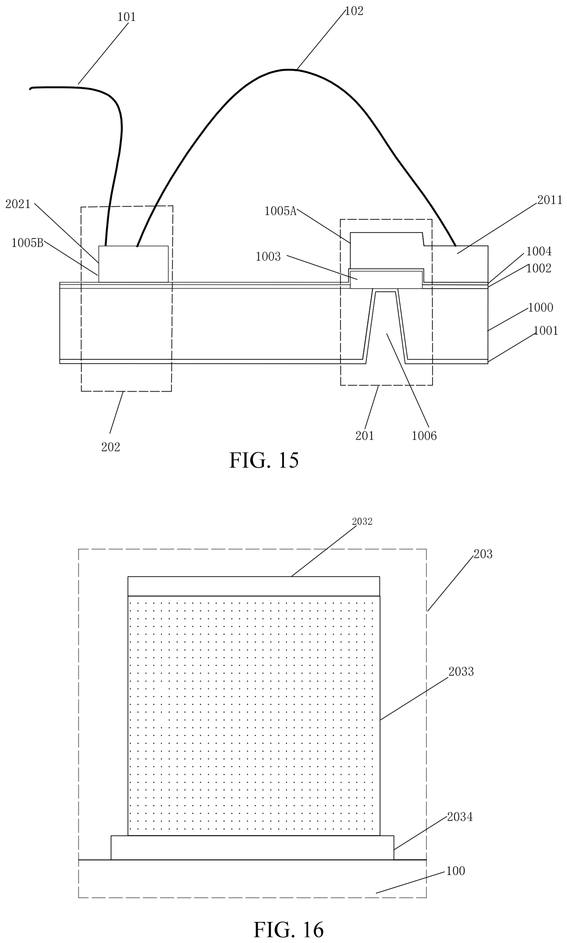

As shown in FIGS. 14 and 16, in some embodiments, the third capacitor 203 is a ceramic capacitor and sequentially includes a first bottom metal layer 2034, a third dielectric layer 2033 and a first top metal layer 2032. A dielectric material of the third dielectric layer 2033 has a dielectric constant $\varepsilon$ ranging from 40 to 200, preferably from 60 to 100. In a specific embodiment, the dielectric material of the third dielectric layer 2033 may be electronic ceramic powder. The area of orthographic projection of the first bottom metal layer 2034 on the supporting substrate 100 is greater than the area of orthographic projection of the first top metal layer 2032 on the supporting substrate. The supporting substrate 100 is an electrically conductive supporting substrate, and the first bottom metal layer 2034 is arranged on the supporting substrate 100. The first top metal layer 2032 is electrically connected to the second connection terminal 402. In one embodiment, the first top metal layer 2032 is electrically connected to the second connection terminal 402 by means of the fourth inductor 104. The second connection terminal 402 is electrically isolated from the supporting substrate 100 by means of an insulating layer 200.

From a top view perspective, the first capacitor 201 is arranged between the first transistor Q1 and the third capacitor 203, and the distance d between the first capacitor 201 and the third capacitor 203 is less than 300 $\mu$m.

In some other embodiments, the first bottom metal layer of the third capacitor may be arranged on the second connection terminal 402, and the first top metal layer 2032 of the third capacitor 203 is electrically connected to the ground terminal GND of the supporting substrate 100 by means of a metal wire.

In the present invention, the first capacitor 201 and the second capacitor 202 are implemented by an integrated capacitor to achieve a high-efficiency decoupling capacitor function, ensuring that the first capacitor 201 and the second capacitor 202 can exhibit near-short-circuit characteristics within a target operating frequency band. According to design requirements, the capacitance is preferably greater than 100 pF. Considering spatial constraints imposed by device packaging, the MiMCAP technique with a dielectric thickness of 4500Å may be adopted to realize a high capacitance density. The third capacitor 203, as a radio frequency matching capacitor, has a capacitance comparable to the output parasitic capacitance Cout to achieve an optimal matching effect. In a specific embodiment, when the capacitance of the third capacitor 203 is less than the output parasitic capacitance of the transistor (generally, less than 100 pF), the third capacitor 203 is implemented by a ceramic capacitor. In some embodiments, the capacitance of the third capacitor 203 is less than 20pF. In such low-capacitance application, the use of an integrated capacitor (such as an MIM capacitor) may increase the burnout risk in actual operation due to the excessively small area of the capacitor. Therefore, in this embodiment, a double-sided ceramic capacitor with a thickness greater than 100 $\mu$m is preferably used for the third capacitor 203, which not only satisfies the capacitance requirement, but also significantly improves the reliability and stability of the device.

The fourth indicator 104 and the third capacitor 203 form an equivalent capacitance at a target operating frequency. Due to the introduction of the fourth inductor 104, the equivalent capacitance exhibits nonlinear characteristics at a specific operating frequency, which makes it possible to reduce the equivalent capacitance within a video bandwidth (VBW) frequency band while satisfying the capacitance requirement at the target operating frequency, thereby enhancing the VBW performance.

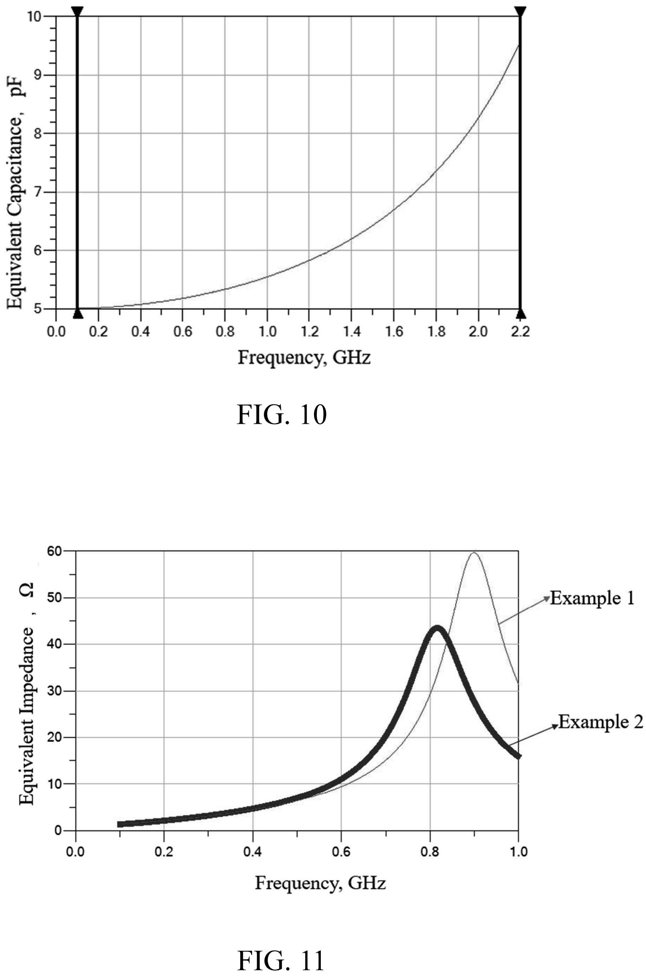

In a particular case where the inductance of the fourth inductor 104 is 0.5 nH and the capacitance of the third capacitor 203 is 5 pF, the equivalent capacitance is 5 pF at a low frequency and is about 9.5 pF at an operating frequency of 2 GHz. The equivalent capacitance achieved by the fourth inductor 104 and the third capacitor 203 is shown in FIG. 10.

Because the series network formed by the fourth inductor 104 and the third capacitor 203 has a nonlinear characteristic, the matching design using the series network formed by the fourth inductor 104 and the third capacitor 203 can increase the video bandwidth at the frequency of around 2 GHz.

FIG. 11 illustrates a comparison chart of VBW resonance points of the present invention with and without the fourth inductor 104. Example 1 adopts the series network formed by the fourth inductor 104 and the third capacitor 203, and Example 2 only adopts the third capacitor 203. It can be seen, from FIG. 11, that the VBW resonant frequency in Example 1 is increased from about 800 MHz to about 900 HMz.

Further, the capacitance of the second capacitor is C2, the inductance of the second inductor 102 is L2, and the value of C2 satisfies:

$$C2 < \frac{2}{(2*\omega)^2 * L2} \qquad\qquad (2)$$

where, $\omega = 2\pi f0$, $f0$ is a fundamental frequency of the radio frequency power amplifier.

Such a condition allows an imaginary part of the impedance to be in a nonlinear relationship with the frequency, exerting a small influence on the imaginary part at $f0$ while exerting a significant influence on the imaginary part at $2f0$, thereby achieving overall matching, optimizing the second harmonic impedance to an optimal value at the $f0$ band under a small electrical length.

The first capacitor 201, as a decoupling capacitor, exhibits such a capacitance value within the radio frequency band that makes it act as a short circuit, so when the first capacitor 201 is short-circuited, an imaginary part of the first harmonic tuning network 31 is given by expression 3:

$$imag = j * \omega * \left(L1 + \frac{L2}{1 - \omega^2 * L2 * C2}\right) \#(3)$$

The physical properties determine that $\omega^2 * L2 * C2 > 0$, so when $\omega^2 * L2 * C2 < 1$, the total inductance of the first parasitic capacitance resonance network 3 will increase nonlinearly with frequency. To ensure that the first parasitic capacitance resonance network 3 exhibits the inductive characteristics at the $f0$ frequency band, the value range of the capacitance value C2 of the second capacitor is defined by expression 4:

$$C2 < \frac{2}{(2 * \omega)^2 * L2} \#(4)$$

In designing a 300 W power amplifier operating at 2GHz (f0 = 2GHz), the inductance of the first inductor 101 is L1, the inductance of the second inductor 102 is L2, given L2=L1=0.4nH, the capacitance C2 satisfies C2<7.91 pF.

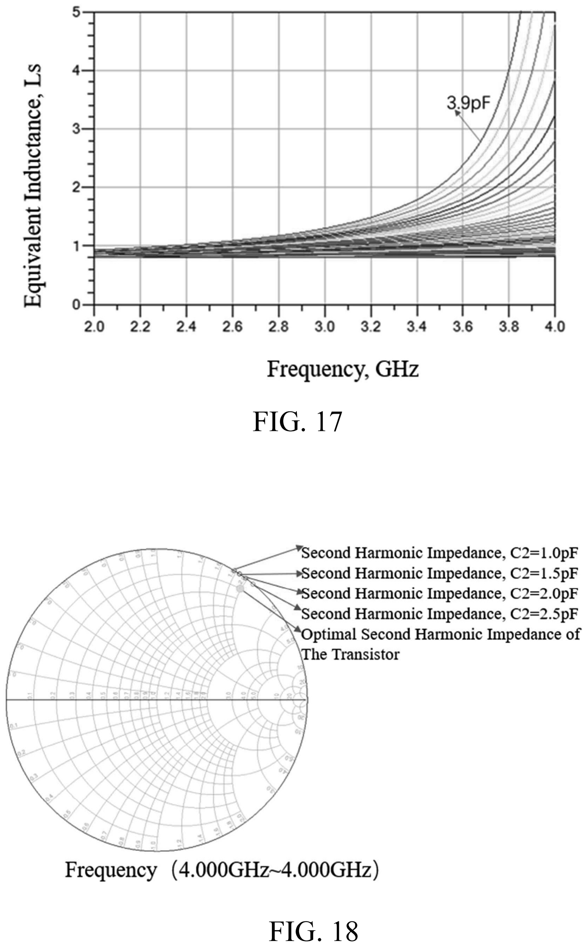

FIG. 17 illustrates the change of the equivalent inductance (unit: nH) of the first harmonic tuning network 31 as the capacitance C2 of the second capacitor is swept from 0.1 pF to 3.9 pF. It can be seen, from FIG. 17, that when C2 is within the range given by expression (4), the overall equivalent inductance of the first parasitic capacitance resonance network 3 exhibits a nonlinear variation characteristic. Specifically, at the fundamental frequency $f0$ (2 GHz), the equivalent inductance changes slightly; and at the second harmonic frequency $2f0$ (4 GHz), the equivalent inductance changes greatly. In addition, with the increase in the capacitance C2, the nonlinear characteristic becomes more remarkable.

By adding the second capacitor 202 to the first parasitic capacitance resonance network 3, the equivalent inductance of the first parasitic capacitance resonance network 3 changes nonlinearly with frequency. It should be noted that the degree of nonlinearity increases with the increase in the capacitance C2 of the second capacitor. However, if the capacitance C2 is too large, the first parasitic capacitance resonance network 3 will exhibit the capacitive characteristics rather than the inductive characteristics as desired. Therefore, the capacitance C2 of the second capacitor has an upper limit, according to expression (4).

As shown in FIG. 17, when C2=3.9 pF, the equivalent inductance of the first parasitic capacitance resonance network 3 is about 0.9 nH at 2 GHz and is over 5 nH at 3.8 GHz. The change in equivalent inductance with frequency is used to tune the second harmonic impedance for optimal amplifier performance by adjusting the inductive reactance at the harmonic frequency.

FIG. 18 illustrates a variation of the impedance of a node B within the second harmonic frequency band as the capacitance C2 of the second capacitor is swept from 1 pF to 3 pF. The node B is located at the position shown in FIG. 1. It may be seen, from FIG. 18, that the impedance rotates clockwise with the increase in C2 from 1 pF to 3 pF.

It can be seen from the above analysis that with the increase in the capacitance C2 of the second capacitor, the equivalent capacitance of the first parasitic capacitance resonance network 3 within the second harmonic frequency band increases accordingly (as shown in FIG. 17). When the equivalent inductance within the second harmonic frequency band increases, the second harmonic impedance of the transistor matching network moves clockwise on the Simth chart with the increase in the capacitance C2 of the second capacitor. Specifically, in the illustrated example, the value range of C2 is 1 pF to 2.5 pF and includes key values 1.0 pF, 1.5 pF, 2.0 pF and 2.5 pF.

In this example, the area indicated by a bottommost arrow (which is highlighted in bright blue in the China priority application) indicates the optimal second harmonic impedance. It is found by analysis that when C2 is about 2 pF, the second harmonic impedance of the first parasitic capacitance resonance network 3 is closest to the optimal second harmonic impedance of the transistor. Therefore, for such a design, when C2 is about 2 pF, the optimal second harmonic impedance matching can be achieved.

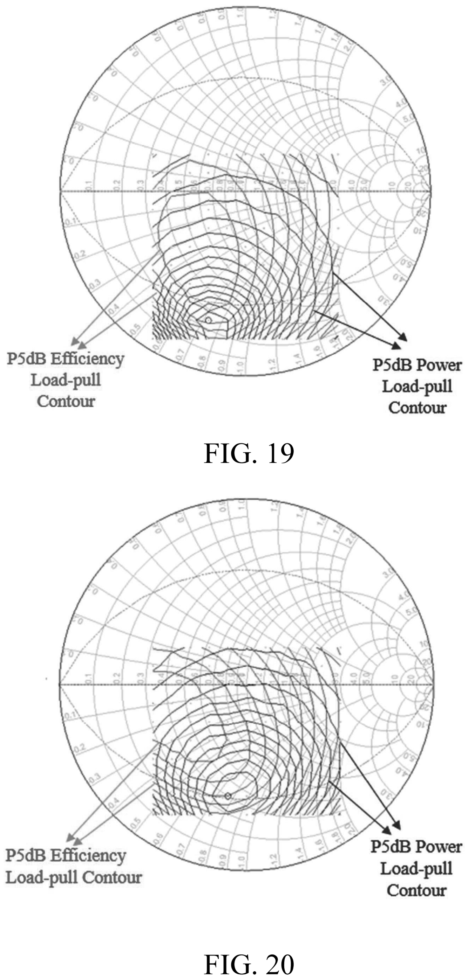

FIG. 19 illustrates load-pull simulation results of a power amplifier in a comparative example. The power amplifier in the comparative example does not include the first parasitic capacitance resonance network 3. The simulation results include P5dB power load-pull contours indicated by blue lines (indicated by arrows on the right side) and P5dB efficiency load-pull contours indicated by red lines (indicated by arrows on the left side). The maximum power at a 5dB compression point is 320.74 dBm, and the maximum efficiency at the 5dB compression point is 73.3%.

FIG. 20 illustrates load-pull simulation results of the power amplifier in Embodiment 1 of the present invention. The simulation results include P5dB power load-pull contours indicated by blue lines (indicated by arrows on the right side) and P5dB efficiency load-pull contours indicated by red lines (indicated by arrows on the left side). The maximum power at a 5dB compression point is 308.11 dBm, and the maximum efficiency at the 5dB compression point is 85%. It can be seen from the above load-pull test results that compared with the load-pull results of the power amplifier in which the first parasitic capacitance resonance network does not include the second capacitor 202, the impedance within the operating frequency band of the invention has no obvious change (the power and efficiency contours have no obvious change) after the 2pF second capacitor 202 is introduced into the first parasitic capacitance resonance network. The maximum efficiency of the present invention is improved to 85% from 73.3% of the comparative example.

It can be seen from the results shown in FIGS. 19 and 20, that the efficiency of the power amplifier provided by the invention is significantly improved. As evidenced by the experimental measurements, under the $f0$ fundamental load-pull testing conditions, the efficiency is improved to 85% from approximately 73% in the comparative example.

**Embodiment 2**

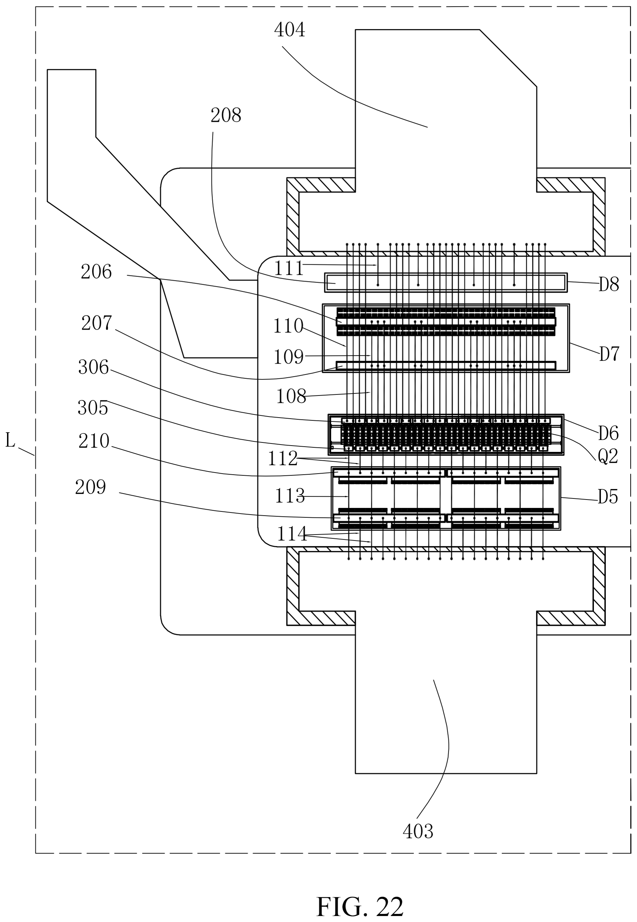

Referring to FIGS. 12 and 22, a radio frequency power amplifier according to this embodiment includes a supporting substrate, a first amplifying branch (the right half in FIG. 12, i.e., a peak amplifying branch, see the detailed description in Embodiment 1), and a second amplifying branch. As described above, the supporting substrate may be a conductive supporting substrate and is provided with the ground terminal GND. The first amplifying branch and the second amplifying branch are packaged in the radio frequency power amplifier.

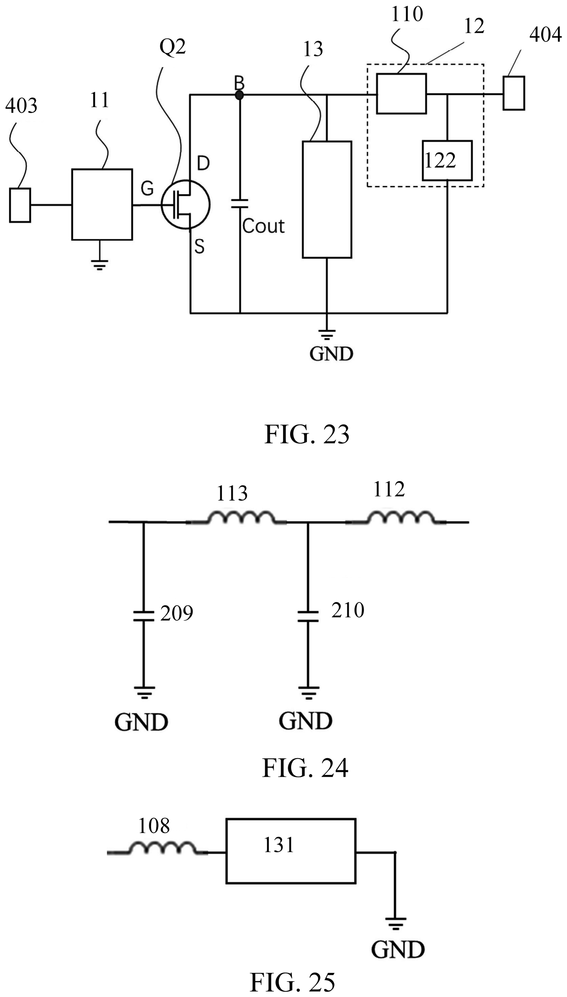

Referring to FIG. 23, the second amplifying branch (the left half L in FIG. 12, i.e., a carrier amplifying branch) includes a third connection terminal 403 (for radio frequency signal input), a fourth connection terminal 404 (for radio frequency signal output), a third impedance matching network 11, a fourth impedance matching network 12, a second transistor Q2 (arranged in a sixth element region D6), and a second parasitic capacitance resonance network 13. The second transistor Q2 includes a gate 305 and a drain 306.

The third impedance matching network 11 is electrically connected between the third connection terminal 403 and the gate 305 of the second transistor Q2. The fourth impedance matching network 12 is electrically connected between the drain 306 of the second transistor Q2 and the fourth connection terminal 404. The second parasitic capacitance resonance network 13 is electrically connected between the drain 306 of the second transistor and the ground terminal GND. The second parasitic capacitance resonance network 13 is configured to resonate with an output parasitic capacitance of the second transistor Q2 and participate in fundamental matching, and exhibits inductive characteristics within a fundamental frequency band of the radio frequency power amplifier.

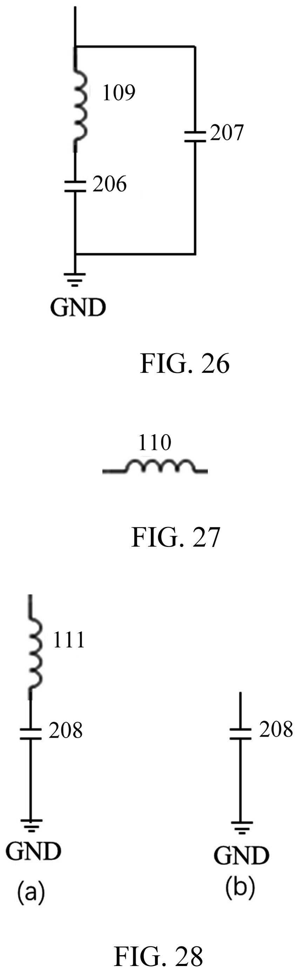

Referring to FIG. 25 and FIG. 26, the second parasitic capacitance resonance network 13 includes an eighth inductor 108 and a second harmonic tuning network 131. The second harmonic tuning network 131 is configured to adjust the phase of the impedance at a second harmonic 2f0. The second harmonic tuning network 131 includes a ninth inductor 109, a sixth capacitor 206, and a seventh capacitor 207. The sixth capacitor 206 and the seventh capacitor 207 are arranged in a seventh element region D7. One terminal of the eighth inductor 108 is electrically connected to the drain 305 of the second transistor; the other terminal of the eighth inductor 108 is electrically connected to one terminal of the ninth inductor 109, and the other terminal of the ninth inductor 109 is electrically connected to one terminal of the sixth capacitor 206; the other terminal of the sixth capacitor 206 is electrically connected to the ground terminal GND; and one terminal of the seventh capacitor 207 is connected to a joint between the eighth inductor 108 and the ninth inductor 109, and the other terminal of the seventh capacitor 207 is connected to the ground terminal GND.

The capacitance value of the seventh capacitor is C7, the inductance value of the ninth inductor 109 is L9, and the value of C7 satisfies:

$$C7 < \frac{2}{(2*\omega)^2*L9}$$ ; where, $\omega = 2\pi f0$; $f0$ is the fundamental frequency of the radio frequency power amplifier.

The sixth capacitor 206 and the seventh capacitor 207 are formed by a third integrated capacitor. The third integrated capacitor includes a third region where the sixth capacitor 206 is arranged and a fourth region where the seventh capacitor 207 is arranged. The third integrated capacitor includes a third semiconductor substrate. The third semiconductor substrate includes a first surface, and a second surface opposite to the first surface. A third backside metal layer is arranged on the second surface of the third semiconductor substrate. The sixth capacitor 206 includes an MIM capacitor formed by a fourth metal layer, a fifth dielectric layer and a fifth metal layer that are arranged in the third region on the first surface of the third semiconductor substrate. The seventh capacitor 207 includes a fourth dielectric layer, a fifth dielectric layer and a sixth metal layer that are arranged in the fourth region on the first surface of the third semiconductor substate, and the third backside metal layer arranged on the second surface of the third semiconductor substrate. The third semiconductor substate is provided with a through-hole, the through-hole is formed in the third region, and the through-hole is provided with the third backside metal layer. The third backside metal layer in the through-hole is in contact with the fourth metal layer in the third region.

The thickness of the fourth dielectric layer is greater than the thickness of the fifth dielectric layer. The fifth metal layer in the third region is electrically isolated from the sixth metal layer in the fourth region. The distance between the second metal layer in the third region and the fourth metal layer in the fourth region is greater than 100 μm.

The fourth dielectric layer is made from silicon nitride or silicon oxide, and the fifth dielectric layer is made from silicon nitride or silicon oxide.

Referring to FIG. 24, the third impedance matching network 11 includes a twelfth inductor 112, a thirteenth inductor 113, a ninth capacitor 209 and a tenth capacitor 210. The ninth capacitor 209 and the tenth capacitor 210 are arranged in a fifth element region D5. The ninth capacitor 209 and the tenth capacitor 210 are formed by a fourth integrated capacitor. The third impedance matching network 11 is configured to resonate with an input parasitic capacitance of the second transistor Q2 and participate in fundamental matching. One terminal of the thirteenth inductor 113 is electrically connected to the third connection terminal 403 by means of a second group of bonding wires 114, the other terminal of the thirteenth inductor 113 is electrically connected to one terminal of the twelfth inductor 112, and the other terminal of the twelfth inductor 112 is electrically connected to the gate 305 of the second transistor. The ninth capacitor 209 is connected in parallel between one terminal of the thirteenth inductor 113 and the ground terminal, i.e. one terminal of the ninth capacitor 209 is electrically connected to the one terminal of the thirteenth inductor 113, and the other terminal of the ninth capacitor 209 is electrically connected to the ground terminal GND. The tenth capacitor 210 is connected in parallel between the other terminal of the thirteenth inductor 113 and the ground terminal GND, i.e., one terminal of the tenth capacitor 210 is electrically connected to the other terminal of the thirteenth inductor 113, and the other terminal of the tenth capacitor 210 is electrically connected to the ground terminal GND.

As shown in FIG. 23, the fourth impedance matching network 12 is configured to form a bandpass matching network to improve the output impedance at the fundamental frequency, and includes a parallel branch 122 and a series branch. One terminal of the series branch is connected to the drain 306 of the second transistor Q2, and the other terminal of the series branch is connected to the fourth connection terminal 404. One terminal of the parallel branch 122 is connected to the fourth connection terminal 404, and the other terminal of the parallel branch 122 is connected to the ground terminal GND.

In one implementation, the fourth impedance matching network 12 includes a tenth inductor 110 (FIG. 27) and an eighth capacitor 208 (FIG. 28(b)), the tenth inductor 110 forming the series branch, the eighth capacitor 208 forming the parallel branch. One terminal of the tenth inductor 110 is electrically connected to the drain 306 of the second transistor Q2, the other terminal of the tenth inductor 110 is electrically connected to the fourth connection terminal 404, and the eighth capacitor 208 is connected in parallel between the fourth connection terminal 404 and the ground terminal, i.e., one terminal of the eighth capacitor 208 is electrically connected to the fourth connection terminal 404, and the other terminal of the eighth capacitor 208 is electrically connected to the ground terminal GND. In another implementation, the fourth impedance matching network 12 includes a tenth inductor 110 (FIG. 7), an eleventh inductor 111 and an eighth capacitor 208 (FIG. 28(a)), the tenth inductor 110 forming the series branch, the eleventh inductor 111 and the eighth capacitor 208 forming the parallel branch 122. One terminal of the tenth inductor 110 is electrically connected to the drain 306 of the second transistor; the other terminal of the tenth inductor 110 is electrically connected to the fourth connection terminal 404; one terminal of the eleventh inductor 111 is electrically connected to the fourth connection terminal 404, and the other terminal of the eleventh inductor 111 is connected to one terminal of the eighth capacitor 208; and the other terminal of the eighth capacitor 208 is electrically connected to the ground terminal GND.

The eighth capacitor 208 is arranged in an eighth element region D8 and, in some embodiments, is a ceramic capacitor. The eighth capacitor 208 includes a second bottom metal layer, a second top metal layer and a sixth dielectric layer. The second bottom metal layer is arranged on the supporting substrate. The value range of the dielectric constant of a dielectric material of the sixth dielectric layer is 40-200. Preferably, the value range of the dielectric constant of the dielectric material of the sixth dielectric layer is 60-100. The dielectric material of the sixth dielectric layer may be electronic ceramic powder. The area of orthographic projection of the second bottom metal layer on the supporting substrate is greater than the area of orthographic projection of the second top metal layer on the supporting substrate.

In the embodiments of the invention, preferably, the first transistor Q1 is a GaN HEMT device, and the second transistor Q2 is a GaN HEMT device. The first amplifying branch has been described in detail in Embodiment 1. The second amplifying branch has an identical topology to the first amplifying branch. The working principle and beneficial effects of the second amplifying branch are similar to those of the first amplifying branch, detailed explanations of which are therefore omitted herein in the present embodiment.

## Embodiment 3

Correspondingly, this embodiment of the invention further provides a communication device, including the radio frequency power amplifier according to Embodiment 1 or 2. The communication device may be a microwave system, a radar, a wireless communication module, a network device, or the like.

Finally, it should be noted that the above embodiments are merely illustrative of the technical solutions of the invention and should not be construed as limitations thereto. Although the invention has been described in detail with reference to the above embodiments, those of ordinary skill in the art should understand that modifications may be made to the technical solutions in the above embodiments or equivalent substitutions may be made to all or part of the technical features in the above embodiments without departing from the scope of the technical solutions in the embodiments of the invention. Any simple modification, equivalent transformation and improvement made to the above embodiments according to the technical essence of the invention shall fall within the protection scope of the technical solutions of the invention.

## Claims

1.　A radio frequency power amplifier, **characterized by** comprising:

　　a supporting substrate (100) and a first amplifying branch, wherein the supporting substrate (100) is provided with a ground terminal (GND); wherein the first amplifying branch comprises a first connection terminal (401), a second connection terminal (402), a first impedance matching network (1), a second impedance matching network (2), a first transistor (Q1), and a first parasitic capacitance resonance network (3); wherein, the first transistor (Q1) comprises a gate (303) and a drain (304); the first impedance matching network (1) is electrically connected between the first connection terminal (401) and the gate (303) of the first transistor (Q1); the second impedance matching network (2) is electrically connected between the drain (304)_of the first transistor (Q1) and the second connection terminal (402); the first parasitic capacitance resonance network (3) is electrically connected between the drain (304) of the first transistor (Q1) and the ground terminal (GND); the first parasitic capacitance resonance network (3) is configured to resonate with an output parasitic capacitance of the first transistor (Q1) and participate in fundamental matching, and exhibit inductive characteristics within a fundamental band of the radio frequency power amplifier.

2.　The radio frequency power amplifier according to Claim 1, **characterized in that**,

the first parasitic capacitance resonance network (3) comprises a first inductor (101) and a first harmonic tuning network (31);

the first harmonic tuning network (31) comprises a second inductor (102), a first capacitor (201) and a second capacitor (202);

one terminal of the first inductor (101) is electrically connected to the drain (304) of the first transistor (Q1);

the other terminal of the first inductor (101) is electrically connected to one terminal of the second inductor (102);

the other terminal of the second inductor (102) is electrically connected to one terminal of the first capacitor (201);

the other terminal of the first capacitor (201) is electrically connected to the ground terminal (GND);

one terminal of the second capacitor (202) is connected to a joint between the first inductor (101) and the second inductor (102);

the other terminal of the second capacitor (202) is connected to the ground terminal (GND).

3. The radio frequency power amplifier according to Claim 2, **characterized in that**, a capacitance of the second capacitor (202) is C2, an inductance of the second inductor (102) is L2, and a value of C2 satisfies:

$$C2 < \frac{2}{(2*\omega)^2 * L2};$$

where, $\omega = 2\pi f0$, and $f0$ is a fundamental frequency of the radio frequency power amplifier.

4. The radio frequency power amplifier according to Claim 2 or 3, **characterized in that**,

the first capacitor (201) and the second capacitor (202) are formed by a first integrated capacitor;

the first integrated capacitor comprises a first region where the first capacitor (201) is arranged and a second region where the second capacitor (202) is arranged;

the first integrated capacitor comprises a first semiconductor substrate (1000); the first semiconductor substrate (1000) comprises a first surface and a second surface opposite to the first surface, a first backside metal layer (1001) being arranged on the second surface of the first semiconductor substrate (1000);

the first capacitor (201) comprises an MIM capacitor formed by a first metal layer (1003), a second dielectric layer (1004) and a second metal layer (1005A) which are arranged in the first region on the first surface of the first semiconductor substrate (1000);

the second capacitor (202) comprises a first dielectric layer (1002), the second dielectric layer (1004) and a third metal layer (1005B) which are arranged in the second region on the first surface of the first semiconductor substate (1000), and the first backside metal layer (1001) arranged on the second surface of the first semiconductor substrate (1000);

the first semiconductor substrate (1000) is provided with a through-hole, the through-hole is formed in the first region, and the through-hole is provided with the first backside metal layer (1001); the first backside metal layer (1001) in the through-hole is in contact with the first metal layer (1003) in the first region.

5. The radio frequency power amplifier according to Claim 4, **characterized in that**,

a thickness of the first dielectric layer is greater than a thickness of the second dielectric layer;

the second metal layer (1005A) in the first region is electrically isolated from the third metal layer (1005B) in the second region, and a distance between the second metal layer (1005A) in the first region and the third metal layer (1005B) in the second region is greater than or equal to 100 μm.

6. The radio frequency power amplifier according to Claim 4 or 5, **characterized in that**, the first dielectric layer (1002) is made from silicon nitride or silicon oxide, and the second dielectric layer (1004) is made from silicon nitride or silicon oxide.

7. The radio frequency power amplifier according to any of Claims 1 to 6, **characterized in that**,

the first impedance matching network (1) comprises a fifth inductor (105), a sixth inductor (106), a fourth capacitor (204) and a fifth capacitor (205);

the first impedance matching network (1) is configured to resonate with an input parasitic capacitance of the first transistor (Q1) and participate in fundamental matching;

one terminal of the sixth inductor (106) is electrically connected to the first connection terminal (401) by means of a group of bonding wires, the other terminal of the sixth inductor (106) is electrically connected to one terminal of the fifth inductor (105), and the other terminal of the fifth inductor (105) is electrically connected to the grate (303) of the first transistor (Q1);

one terminal of the fourth capacitor (204) is electrically connected to the one terminal of the sixth inductor, and the other terminal of the fourth capacitor (204) is electrically connected to the ground terminal (GND);

one terminal of the fifth capacitor (205) is electrically connected to the other terminal of the sixth inductor (106), and the other terminal of the fifth capacitor (205) is electrically connected to the ground terminal (GND).

8. The radio frequency power amplifier according to any of Claims 1 to 7, **characterized in that**,

the second impedance matching network (2) comprises a third inductor (103) and a third capacitor (203);

one terminal of the third inductor (103) is electrically connected to the drain (304) of the first transistor (Q1);

the other terminal of the third inductor (103) is electrically connected to the second connection terminal (402);

one terminal of the third capacitor (203) is electrically connected to the second connection terminal (402), and the other terminal of the third capacitor (203) is connected to the ground terminal (GND).

9. The radio frequency power amplifier according to any of Claims 1 to 7, **characterized in that**,

the second impedance matching network (2) comprises a third inductor (103), a fourth inductor (104) and a third capacitor (203);

one terminal of the third inductor (103) is electrically connected to the drain (304) of the first transistor (Q1);

the other terminal of the third inductor (103) is electrically connected to the second connecting terminal (402);

one terminal of the fourth inductor (104) is electrically connected to the second connection terminal (402), and the other terminal of the fourth inductor (104) is connected to one terminal of the third capacitor (203); the other terminal of the third capacitor (203) is electrically connected to the ground terminal (GND).

10. The radio frequency power amplifier according to Claim 9, **characterized in that**,

the third capacitor (203) is a ceramic capacitor and sequentially comprises a first bottom metal layer (2034), a third dielectric layer (2033) and a first top metal layer (2032); the first bottom metal layer (2034) is arranged on the supporting substrate (100), and the first top metal layer (2032) of the third capacitor (203) is electrically connected to the second connection terminal (402); or,

the first bottom metal layer (2034) of the third capacitor (203) is arranged on the second connection terminal (402); and the first top metal layer (2032) of the third capacitor (203) is electrically connected to the ground terminal (GND) of the supporting substrate (100) by means of a metal wire.

11. The radio frequency power amplifier according to Claim 10, **characterized in that**,
a dielectric material of the third dielectric layer (2033) has a dielectric constant in the range of 40-200.

12. The radio frequency power amplifier according to Claim 10, **characterized in that**,
a capacitance of the third capacitor (203) is less than 100 pF, and a thickness of the third dielectric layer (2033) is greater than or equal to 100 $\mu$m.

13. The radio frequency power amplifier according to Claim 9, **characterized in that**,
the first capacitor (201) is arranged between the first transistor (Q1) and the third capacitor (203), and a distance between the first capacitor (201) and the third capacitor (203) is less than 300 $\mu$m.

14. The radio frequency power amplifier according to any of Claims 1-13, **characterized in that**:

the radio frequency power amplifier further comprises a second amplifying branch,

the first amplifying branch is configured for peak amplification;

the second amplifying branch is configured for carrier amplification; the second amplifying branch comprises a third connection terminal (403), a fourth connection terminal (404), a third impedance matching network (11), a fourth impedance matching network (12), a second transistor (Q2) and a second parasitic capacitance resonance network (13);

the second transistor (Q2) comprises a gate (305) and a drain (306);

the third impedance matching network (11) is electrically connected between the third connection terminal (403) and the gate (305) of the second transistor (Q2);

the fourth impedance matching network (12) is electrically connected between the drain (306) of the second transistor (Q2) and the fourth connection terminal (404);

the second parasitic capacitance resonance network (13) is electrically connected between the drain (306) of the second transistor (Q2) and the ground terminal (GND);

the second parasitic capacitance resonance network (13) is configured to resonate with an output parasitic capacitance of the second transistor (Q2) and participate in fundamental matching, and exhibit inductive characteristics within the fundamental band of the radio frequency power amplifier.

15. A communication device, comprising the radio frequency power amplifier according to any one of Claims 1-14.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

FIG. 17

FIG. 18

P5dB Efficiency
Load-pull
Contour

P5dB Power
Load-pull
Contour

FIG. 19

P5dB Efficiency
Load-pull Contour

P5dB Power
Load-pull
Contour

FIG. 20

FIG. 21

FIG. 22

FIG. 23

FIG. 24

FIG. 25

FIG. 26

FIG. 27

FIG. 28

# EUROPEAN SEARCH REPORT

**Application Number**

EP 25 21 9920

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/229077 A1 (DE BOET JOHANNES ADRIANUS MARIA [NL] ET AL) 25 July 2019 (2019-07-25) | 1-3,7-15 | INV.<br>H03F1/56<br>H03F3/195 |
| A | * paragraph [0002] - paragraph [0046]; claims 1, 19; figures 1-8 * | 4-6 | H03F3/21<br>H03F1/02 |
| X | US 2012/218040 A1 (TAKAGI KAZUTAKA [JP] ET AL) 30 August 2012 (2012-08-30) | 1-3,7-15 | |
| A | * paragraph [0074] - paragraph [0089]; figures 14-18 * | 4-6 | |
| A | WO 2022/271017 A1 (AMPLEON NETHERLANDS BV [NL]) 29 December 2022 (2022-12-29) * page 10, line 5 - line 14; figure 5 * | 7 | |
| A | WO 2020/256554 A1 (AMPLEON NETHERLANDS BV [NL]) 24 December 2020 (2020-12-24) * paragraph [0060] * * paragraph [0018] - paragraph [0124]; figures 1-6 * | 7,10 | |
| A | US 2024/171132 A1 (BOLLINGER LAURE [FR] ET AL) 23 May 2024 (2024-05-23) * page 13, line 30 - page 16, line 6; figures 7-10 * | 7 | **TECHNICAL FIELDS SEARCHED (IPC)**<br><br>H03F |

The present search report has been drawn up for all claims

| Place of search | Date of completion of the search | Examiner |
|---|---|---|
| The Hague | 15 May 2026 | Wienema, David |

EPO FORM 1503 03.82 (P04C01)

## ANNEX TO THE EUROPEAN SEARCH REPORT
## ON EUROPEAN PATENT APPLICATION NO.

EP 25 21 9920

This annex lists the patent family members relating to the patent documents cited in the above-mentioned European search report.
The members are as contained in the European Patent Office EDP file on
The European Patent Office is in no way liable for these particulars which are merely given for the purpose of information.

15-05-2026

| Patent document cited in search report | | Publication date | Patent family member(s) | | Publication date |
|---|---|---|---|---|---|
| US 2019229077 | A1 | 25-07-2019 | CN | 109643976 A | 16-04-2019 |
| | | | EP | 3504792 A1 | 03-07-2019 |
| | | | US | 2019229077 A1 | 25-07-2019 |
| | | | WO | 2018038606 A1 | 01-03-2018 |
| US 2012218040 | A1 | 30-08-2012 | JP | 5450479 B2 | 26-03-2014 |
| | | | JP | 2012182560 A | 20-09-2012 |
| | | | US | 2012218040 A1 | 30-08-2012 |
| WO 2022271017 | A1 | 29-12-2022 | CN | 117678156 A | 08-03-2024 |
| | | | DE | 112022003214 T5 | 04-04-2024 |
| | | | NL | 2028527 B1 | 02-01-2023 |
| | | | US | 2024291437 A1 | 29-08-2024 |
| | | | WO | 2022271017 A1 | 29-12-2022 |
| WO 2020256554 | A1 | 24-12-2020 | CN | 113994589 A | 28-01-2022 |
| | | | US | 2022246553 A1 | 04-08-2022 |
| | | | WO | 2020256554 A1 | 24-12-2020 |
| US 2024171132 | A1 | 23-05-2024 | CN | 118057724 A | 21-05-2024 |
| | | | EP | 4372984 A1 | 22-05-2024 |
| | | | US | 2024171132 A1 | 23-05-2024 |

EPO FORM P0459

For more details about this annex : see Official Journal of the European Patent Office, No. 12/82